# EUROPÄISCHE PATENTSCHRIFT

(11) **EP 3 944 430 B1**
(45) Veröffentlichungstag und Bekanntmachung des Hinweises auf die Patenterteilung: **08.04.2026**
(21) Anmeldenummer: 21185701.6
(22) Anmeldetag: 15.07.2021
(51) Int. Cl.: H01R 13/6474, H01R 12/72

(54) **KONTAKTVORRICHTUNG**
CONTACT DEVICE
DISPOSITIF DE CONNEXION

(30) Priorität: 22.07.2020 DE 102020119282
(43) Veröffentlichungstag der Anmeldung: 26.01.2022
(73) Patentinhaber: MD ELEKTRONIK GmbH, 84478 Waldkraiburg (DE)
(72) Erfinder: Bock, Daniel, 84573 Schönberg (DE); Schroll, Dominik, 84539 Ampfing (DE); Grasser, Thomas, 83536 Gars am Inn (DE); Halbig, Thomas, 92345 Dietfurt (DE)
(74) Vertreter: Kehl, Ascherl, Liebhoff & Ettmayr Patentanwälte Partnerschaft mbB

(56) Entgegenhaltungen:
- EP-A1- 2 184 810
- US-A1- 2016 126 658
- US-A1- 2016 276 780
- US-B2- 6 923 664

## Beschreibung

### Technisches Gebiet

Die Erfindung betrifft eine Kontaktvorrichtung zur Aufnahme eines Steckerendes.

### Stand der Technik

Die vorliegende Erfindung wird hauptsächlich in Verbindung mit Leitungen und Steckern zur symmetrischen Datenübertragung beschrieben. Es versteht sich aber, dass die vorliegende Erfindung in allen Anwendungen genutzt werden kann, in welchen mehrere Leiter über einen Stecker bzw. eine Steckeraufnahme oder Buchse kontaktiert werden sollen.

In modernen Anwendungen der Datenverarbeitung steigen die in einem System zu übertragenden Datenmengen kontinuierlich an. Beispielsweise werden in Fahrzeugen Funktionen zum teilautonomen oder vollständig autonomen Fahren des Fahrzeugs implementiert, für die eine Vielzahl von Sensordaten und Steuerdaten übertragen werden müssen.

Zur Verbindung der einzelnen Komponenten eines solchen Systems, also z.B. der Steuergeräte, Sensoren und Aktoren, wird eine Vielzahl von Kabeln, Steckern und entsprechenden Buchsen bzw. Steckeraufnahmen benötigt. Auf Grund der positiven Eigenschaften für die Datenübertragung, insbesondere der großen Immunität gegen externe Störeinflüsse, werden in solchen Systemen häufig symmetrische Datenübertragungssysteme eingesetzt. Solche symmetrischen Datenübertragungssysteme nutzen z.B. sog. Twisted-Pair Kabel, in welchen ineinander verdrillte Leiterpaare zur Datenübertragung genutzt werden.

Um insbesondere bei hohen Übertragungsfrequenzen die Qualität der Datenübertragung sicherzustellen, sollte in solchen Systemen die charakteristische Impedanz der Gegentaktmode über die Leitungslänge konstant sein. Weiterhin sollte für einen beliebigen Leitungsabschnitt die Eigeninduktivität der einzelnen Leitungen eines Leiterpaares sowie die Kapazität zum leitenden Gehäuse gleich sein. Datenübertragungsstrecken für die einzelnen Leitungen eines Leiterpaares möglichst gleich lang sein. Ferner sollten die Kapazitäten auf der Leiterstrecke möglichst konstant sein.

An den Anschlussstellen, an welchen ein solches Twisted-Pair Kabel mit einem Gerät, z.B. einem Fahrzeugsteuergerät verbunden wird, kommen daher entsprechende Steckeraufnahmen bzw. Buchsen zum Einsatz, in welchen die Kontakte gleich lang und nebeneinander parallel zueinander geführt werden. So kann für eine solche Steckeraufnahme bzw. Buchse sichergestellt werden, dass die Datenübertragungsstrecken gleich lang und die Kapazitäten konstant sind.

Da die einzelnen Kontakte in einer solchen Steckeraufnahme bzw. Buchse nebeneinander angeordnet sind, beansprucht eine solche Steckeraufnahme bzw. Buchse einen entsprechenden Bauraum z.B. auf eine Trägerplatine.

Dokumente EP 2 184 810 A1, US 2016 / 126 658 A1, US 2016 / 276 780 A1 und US 6 923 664 B2 zeigen jeweils Platinenverbinder.

### Beschreibung der Erfindung

Es ist eine Aufgabe der vorliegenden Erfindung, den Bauraumbedarf zur Aufnahme von Steckern an einem Gerät zu reduzieren.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Die vorliegende Erfindung basiert auf der Erkenntnis, dass in einer Steckeraufnahme bzw. Buchse nebeneinander angeordnete Kontakte zu einem erhöhten Bauraumbedarf in horizontaler Richtung führen. Aber gerade in horizontaler Richtung, also in der Ebene in welcher die Aufnahmeeinrichtung, also z.B. eine Trägerplatine, liegt, ist der Bauraum üblicherweise beschränkt. In vertikaler Richtung dagegen, also von der Trägerplatine ausgehend in die Höhe, steht üblicherweise ausreichend Bauraum zur Verfügung, beispielsweise, weil weitere Bauelemente auf der Platine angeordnet sind, die höher aufbauen als die Steckeraufnahme bzw. Buchse.

In diesem Zusammenhang ist unter dem Begriff Steckerende derjenige Teil eines elektrischen Steckers zu verstehen, der in eine Steckeraufnahme bzw. Buchse eingesteckt wird. Die Kontaktvorrichtung gemäß der vorliegenden Erfindung kann eine solche Steckeraufnahme bzw. Buchse bilden. Die Kontaktvorrichtung kann dabei insbesondere zur Aufnahme von Steckern von Twisted-Pair oder Parallel-Pair Leitungen dienen.

Um den Bauraumbedarf der Steckeraufnahmen bzw. Buchsen, insbesondere in horizontaler Richtung bzw. der Ebene der Trägerplatine, in einem elektrischen Gerät zu reduzieren, sieht die vorliegende Erfindung die Kontaktvorrichtung vor.

Die Kontaktvorrichtung dient der Aufnahme eines Steckerendes eines elektrischen Steckers und der elektrischen Kontaktierung der einzelnen elektrischen Kontakte in dem Steckerende. Die Kontaktvorrichtung kann daher auch als Buchse oder (Stecker-) Aufnahme bezeichnet werden.

In der Kontaktvorrichtung sind ein erster Kontakt und ein zweiter Kontakt vorgesehen. Es versteht sich, dass weitere Kontakte vorgesehen sein können. Für solche weiteren Kontakte, gelten die Erläuterungen und die beanspruchten Merkmale zu dem ersten Kontakt und dem zweiten Kontakt analog. Beispielsweise kann in einer Ausführungsform eine Kontaktvorrichtung mit drei oder vier Kontakten vorgesehen sein.

Ferner versteht sich, dass mehrere Kontaktvorrichtungen in einem Gehäuse zusammengefasst werden können. Beispielsweise können zwei oder mehr Kontaktvorrichtungen in einem gemeinsamen Gehäuse horizontal nebeneinander, also bei Frontalansicht auf die Kontaktenden, angeordnet werden. Im Rahmen der vorliegenden Erfindung sind die Begriffe nebeneinander oder horizontal als nebeneinander bezogen auf die Ebene, in welcher die Aufnahmeeinrichtung liegt, zu verstehen, so lange nicht anders definiert. Entsprechend sind die Begriffe übereinander oder vertikal als übereinander bezogen auf die Ebene, in welcher die Aufnahmeeinrichtung liegt, zu verstehen, so lange nicht anders definiert.

Jeder der Kontakte dient der elektrischen Kontaktierung eines elektrischen Kontakts des Steckerendes und der Kopplung mit einer Aufnahmeeinrichtung, welche die Kontaktvorrichtung aufnimmt. Dazu sehen die Kontakte jeweils ein Koppelende und ein Kontaktende vor.

Das Koppelende dient jeweils der Kontaktierung der Aufnahmeeinrichtung und kann z.B. mit einer Leiterbahn auf einer Trägerplatine verlötet werden. Das Kontaktende dient dazu, den elektrischen Kontakt mit dem entsprechenden elektrischen Kontakt in dem Steckerende herzustellen. Die Kontaktenden können z.B. als sog. Kontaktstifte ausgebildet sein. Alternativ können die Kontaktenden auch als sog. Federkontakte ausgebildet sein, in welche ein Kontaktstift eingeführt werden kann. Es versteht sich, dass jede Form der Kontaktenden möglich ist, welche eine entsprechende elektrische Kontaktierung ermöglicht.

Die Kontaktvorrichtung bietet die Möglichkeit, den ersten Kontakt geometrisch anders auszuformen, als den zweiten Kontakt. Insbesondere im Hinblick auf die Positionen der Kontaktenden und der Koppelenden.

Erfindungsgemäß ist der kürzeste Abstand zwischen dem ersten Koppelende und dem ersten Kontaktende ungleich dem kürzesten Abstand zwischen dem zweiten Koppelende und dem zweiten Kontaktende. Die Koppelenden und die Kontaktenden der Kontakte können länglich ausgedehnt sein. Der Abstand kann daher z.B. ausgehend von den Enden der Koppelenden und Kontaktenden definiert sein.

Bei herkömmlichen Steckern für Twisted-Pair Leitungen liegen identische Kontakte parallel nebeneinander. Solche herkömmlichen Kontakte weisen folglich identische kürzeste Abstände zwischen den Kontaktenden und den Koppelenden auf.

Durch die Kontakte der vorliegenden Erfindung können die Kontaktenden ausgehend von einer Trägerplatine übereinander angeordnet werden. Die Koppelenden dagegen können auf der Platine z.B. nebeneinander angeordnet sein. Gleichzeitig sieht die vorliegende Erfindung vor, dass der erste Kontakt und der zweite Kontakt die gleiche Gesamtlänge aufweisen.

Die Kontakte können länglich ausgebildet sein und dabei eine von einer geraden Form abweichende Form aufweisen. Die Kontakte können folglich entsprechend zumindest abschnittweise geknickt bzw. gebogen sein. Insbesondere die Koppelenden und Kontaktenden können in einer Ausführungsform eine gerade oder annähernd gerade Form aufweisen und länglich ausgebildet sein. Die Kontakte können z.B. als Stanz-Biege-Teile oder als gebogene Drahtstücke ausgebildet sein.

Die vorliegende Erfindung ermöglicht es, die Kontaktvorrichtung bei einer vertikalen Anordnung der zwei Kontaktenden übereinander sehr schmal auszuführen. Es können folglich auf der gleichen Breite z.B. einer Platine mehr Kontaktvorrichtungen als bei herkömmlichen Steckeraufnahmen angeordnet werden.

Gleichzeitig wird dadurch, dass die Kontakte die gleiche Gesamtlänge aufweisen, sichergestellt, dass die Signale auf beiden Leiterstrecken die gleiche Laufzeit aufweisen.

Die Definition des ungleichen kürzesten Abstands zwischen dem ersten Koppelende und dem ersten Kontaktende sowie dem zweiten Koppelende und dem zweiten Kontaktende ermöglicht dabei eine sehr flexible Ausgestaltung der zwei Kontakte und führt dazu, dass die zwei Kontakte unterschiedliche Geometrien aufweisen.

Insbesondere können die Kontaktenden z.B. auch aus der vertikalen Ebene gekippt ausgebildet werden, also in einer Frontalansicht auf die Kontaktenden, einen gewissen seitlichen Versatz zueinander aufweisen. Ferner ist es möglich, die Koppelenden sehr flexibel auf der Aufnahmeeinrichtung zu positionieren. Es muss dabei lediglich auf die gleiche Gesamtlänge der Kontakte geachtet werden. Dabei kann insbesondere auch vorgesehen sein, dass die Gesamtlänge des ersten Kontakts gleich der Gesamtlänge des zweiten Kontakts zuzüglich bzw. abzüglich eines vorgegebenen Toleranzwertes ist. Dieser Toleranzwert kann z.B. abhängig von der Frequenz der zu übertragenden Signale und damit abhängig von der Wellenlänge dieser Signale derart gewählt werden, dass eine fehlerfreie Datenübertragung sichergestellt ist bzw. vom jeweiligen Übertragungssystem vorgegebene Grenzwerte eingehalten werden. Der Toleranzwert kann z.B. zwischen 2 mm und 0 mm, insbesondere zwischen 1 mm und 0 mm, insbesondere auch zwischen 0,5 mm und 0 mm oder 0,2 mm und 0 mm, insbesondere auch zwischen 0,1 mm und 0 mm oder 0,05 mm und 0 mm liegen.

Weitere Ausführungsformen und Weiterbildungen ergeben sich aus den Unteransprüchen sowie aus der Beschreibung unter Bezugnahme auf die Figuren.

In einer Ausführungsform kann über die gesamte Erstreckungslänge der Kontakte der kürzeste Abstand zwischen dem ersten Kontakt und dem zweiten Kontakt maximal um einen vorgegebenen Grenzwert variieren.

Der erste Kontakt und der zweite Kontakt können wie oben bereits erläutert unterschiedliche Geometrien aufweisen. Insbesondere können die Kontakte derart ineinander verwunden sein, dass der Abstand zwischen den Kontakten über ihre gesamte Länge annährend konstant ist. Der Abstand ist dabei jeweils als der kürzeste Abstand zwischen den zwei Kontakten an jedem Punkt über deren gesamte Erstreckungslänge anzusehen.

Der Grenzwert kann z.B. als absoluter Wert definiert werden, also z.B. als Wert in Millimeter. Alternativ kann der Grenzwert auch als relativer Wert definiert werden, also z.B. als Prozentsatz vom größten oder kleinsten vorhandenen Abstand. Nach der Erfindung ist der Grenzwert 1 mm, 0,5 mm oder 0,25 mm betragen. Auch nach der Erfindung kann der Grenzwert 20%, 10% oder 5% betragen.

Der Grenzwert führt dazu, dass die zwei Kontakte zumindest annähernd im gleichen Abstand verlaufen. Kleinere Variationen des Abstands können durch den Grenzwert ebenfalls erfasst werden. Es wird dadurch möglich, die Kapazität zwischen dem ersten Leiter und dem zweiten Leiter einzustellen und nahezu konstant zu halten. Dadurch wird die Qualität der Signalübertragung sichergestellt.

In einer weiteren Ausführungsform kann eine Längserstreckungsrichtung des ersten Koppelendes parallel zu einer Längserstreckungsrichtung des zweiten Koppelendes ausgebildet sein. Ferner kann eine Längserstreckungsrichtung des ersten Kontaktendes parallel zu einer Längserstreckungsrichtung des zweiten Kontaktendes ausgebildet sein.

Wie oben bereits erläutert, können die Koppelenden und die Kontaktenden nahezu gerade ausgebildet sein. In der Kontaktvorrichtung können dann das erste Koppelende und das zweite Koppelende zumindest annähernd parallel zueinander ausgerichtet sein, was dadurch sichergestellt wird, dass deren Längserstreckungsrichtungen parallel liegen. Gleiches gilt auch für das erste Koppelende und das zweite Koppelende.

Die Kontaktenden können folglich als Paar mit einem definierten Abstand und einer definierten Ausrichtung angeordnet werden. Gleiches gilt auch für die Koppelenden.

In noch einer weiteren Ausführungsform kann die Längserstreckungsrichtung des ersten Koppelendes in einem ersten vorgegebenen Winkel zu der Längserstreckungsrichtung des ersten Kontaktendes angeordnet sein. Zusätzlich oder alternativ kann die Längserstreckungsrichtung des zweiten Koppelendes in einem zweiten vorgegebenen Winkel zu der Längserstreckungsrichtung des zweiten Kontaktendes angeordnet sein. Insbesondere kann dabei der erste vorgegebene Winkel dem zweiten vorgegebenen Winkel entsprechen.

Der erste vorgegebene Winkel und der zweite vorgegebene Winkel können z.B. jeweils für eine Projektion der Koppelenden bzw. der Kontaktenden in eine vorgegebene Ebene definiert werden. Diese vorgegebene Ebene kann z.B. durch die Verbindungslinie zwischen dem Ende des ersten Kontaktendes und dem Ende des zweiten Kontaktendes und der Längsachse bzw. Längserstreckungsrichtung des ersten Kontaktendes bzw. des zweiten Kontaktendes definiert sein.

Die vorgegebenen Winkel können z.B. annähernd 90° betragen. In einer solchen Ausführung können die Koppelenden z.B. senkrecht durch eine Leiterplatte geführt werden, während die Kontaktenden parallel zur Ebene der Leiterplatte liegen können.

In einer weiteren Ausführungsform kann eine Verbindungslinie zwischen dem ersten Koppelende und dem zweiten Koppelende in einem dritten vorgegebenen Winkel, insbesondere einem Winkel von 60° bis 120° oder von 70° und 110° oder von 80° bis 100° oder von 85° bis 95° oder einem Winkel von 90°, zu einer Ebene angeordnet sein. Die Ebene kann dabei in der Längserstreckungsrichtung des ersten Kontaktendes und der Längserstreckungsrichtung des zweiten Kontaktendes liegen.

Die Verbindungslinie kann also z.B. senkrecht auf der Ebene durch die Längserstreckungsrichtung des ersten Kontaktendes und die Längserstreckungsrichtung des zweiten Kontaktendes liegen. Allgemein kann in einer Ausführungsform die Verbindungslinie z.B. in einer Ebene liegen, welche in einem vorgegebenen Winkel, also z.B. einem 90° Winkel, zu der Ebene durch die Längserstreckungsrichtung des ersten Kontaktendes und die Längserstreckungsrichtung des zweiten Kontaktendes angeordnet ist. Eine solche Ebene kann also z.B. diejenige Ebene sein, in welcher eine Trägerplatine für die Kontaktvorrichtung liegt.

Bei herkömmlichen Steckerbuchsen liegen z.B. identische Kontakte mit einer 90° Biegung nebeneinander. Die Kontaktenden liegen folglich in einer Ebene parallel zur Ebene der Trägerplatine und beanspruchen einen großen Bauraum in horizontaler Richtung.

Bei der Kontaktvorrichtung gemäß der vorliegenden Erfindung dagegen können die Kontaktenden z.B. über der Ebene in welcher z.B. eine Trägerplatine liegt, vertikal übereinander angeordnet sein. Gleichzeitig können aber die Koppelenden z.B. in der Ebene, in welcher die Trägerplatine liegt, nebeneinander angeordnet sein. Dazu ist es nötig, anstelle der identischen herkömmlichen Kontakte die Kontakte gemäß der vorliegenden Erfindung mit unterschiedlichen Geometrien bereitzustellen.

Liegen die Koppelenden auf der Trägerplatine auf einer Geraden, die parallel zu den Anschlüssen eines Empfängerbausteins (oder eines Senderbausteins) liegt, kann auf der Trägerplatine auf einen Längenausgleich auf Grund unterschiedlicher Abstände der Koppelenden vom jeweiligen Empfängerbaustein verzichtet werden. Damit wird das Layout der Schaltung auf der Trägerplatine erheblich vereinfacht.

In noch einer Ausführungsform kann eine Verbindungslinie zwischen dem ersten Kontaktende und dem zweiten Kontaktende in einem vorgegebenen Winkel, insbesondere einem Winkel von -30° bis 30° oder einem Winkel von -10° bis 10° oder einem Winkel von - 5° bis 5° oder einem Winkel von 0°, zu der Längserstreckungsrichtung des ersten Koppelendes oder der Längserstreckungsrichtung des zweiten Koppelendes angeordnet sein.

Der vorgegebene Winkel kann z.B. jeweils für eine Projektion der Verbindungslinie auf eine Ebene durch die Längserstreckungsrichtung des ersten Koppelendes und die Längserstreckungsrichtung des zweiten Koppelendes definiert werden.

Werden die Kontaktenden in einer Trägerplatine fixiert, ragen diese üblicherweise orthogonal durch die Trägerplatine hindurch. Bei einem Winkel von 0° der Verbindungslinie zwischen dem ersten Kontaktende und dem zweiten Kontaktende stehen die Kontaktenden folglich senkrecht übereinander über der Trägerplatine.

Die vertikale Anordnung der Kontaktenden führt zu einem wesentlich geringeren Bauraumbedarf der Kontaktvorrichtung in horizontaler Richtung bezogen auf z.B. eine Trägerplatine, auf welcher die Kontaktvorrichtung angeordnet ist.

In einer Ausführungsform kann der vorgegebene Winkel aber auch von 0° abweichen und die Kontaktenden folglich schräg übereinander über der Trägerplatine liegen.

In noch einer Ausführungsform können der erste Kontakt und/oder der zweite Kontakt zwischen dem ersten Koppelende und dem ersten Kontaktende einen Längenausgleichsabschnitt aufweisen, welcher insbesondere mäanderförmig ausgebildet sein kann.

Der Längenausgleichabschnitt dient dazu, denjenigen der Kontakte welcher ohne den Längenausgleichabschnitt der kürzere Kontakt wäre, auf die vorgegebene Länge zu verlängern.

Unterschiedlich lange Leitungen führen bei differentieller Signalübertragung zu einer Phasenverschiebung am Leiterende. Das Signal erhält folglich einen Gleichtaktanteil, welcher aus der Überlagerung der phasenverschobenen Einzelsignale resultiert. Ein solcher Gleichtaktanteil führt zur sogenannten Modenumwandlung. Die entstehende Gleichtaktmode kann eine Abstrahlung und damit eine Signalstörung hervorrufen. Ferner können zu große Phasenverschiebungen zwischen den zwei Signalen zu Fehlern beim Signalempfang in dem jeweiligen Empfängerbaustein führen. Lediglich als Beispiel sei hier angeführt, dass z.B. bei PCIe Datenleitungen für eine Datenübertragungsrate von 2,5Gbit/s maximal Längenunterschiede von 0,1mm gefordert werden.

Es ist folglich insbesondere für hohe Datenübertragungsraten vorteilhaft, einen Längenausgleichsabschnitt vorzusehen. Ein solcher Längenausgleichsabschnitt resultiert in größeren Gestaltungsfreiheiten bei den Geometrien der einzelnen Kontakte. Die Kontakte können in einem ersten Schritt ohne Rücksicht auf die resultierende Leiterlänge gestaltet werden. Die Längenunterschiede können im Anschluss mit Hilfe des Längenausgleichsabschnitts korrigiert werden.

Insbesondere in einer Ausführungsform, in welcher die Kontakte mit einem annähernd konstanten Abstand zueinander geführt werden müssen, ist der größere Gestaltungsfreiraum für die Geometrien der Kontakte vorteilhaft.

Unter einem mäanderförmigen Längenausgleichsabschnitt ist zu verstehen, dass der Längenausgleichsabschnitt zumindest eine Ausstülpung aufweist. Dabei kann die Eintrittsrichtung in den Längenausgleichsabschnitt gleich der Austrittsrichtung aus dem Längenausgleichsabschnitt sein. Alternativ kann der Längenausgleichsabschnitt auch in eine der Biegungen des jeweiligen Kontakts integriert werden.

In einer weiteren Ausführungsform kann die Kontaktvorrichtung einen Isolator aufweisen, welcher ausgebildet sein kann, den ersten Kontakt und zweiten Kontakt aufzunehmen, und welcher ein elektrisch isolierendes Material aufweisen kann. Zusätzlich kann die Kontaktvorrichtung einen Außenleiter aufweisen, welcher ausgebildet sein kann, den Isolator aufzunehmen.

Der Isolator dient der Aufnahme und mechanischen Fixierung der Kontakte. Die Kontakte werden durch den Isolator also in der korrekten Position gehalten, wenn diese in dem Isolator liegen.

Ferner dient der Isolator der elektrischen Isolation der Kontakte. Dazu kann der Isolator aus einem entsprechenden Material hergestellt werden. Beispielsweise kann der Isolator aus einem geeigneten Kunststoff hergestellt werden, z.B. im Spritzgussverfahren.

Der Isolator kann in einer Ausführung mechanisch derart ausgebildet sein, dass er auf einem Träger, z.B. einer Trägerplatine, aufgebracht werden kann. In einer Ausführung kann der Isolator dagegen durch einen Außenleiter ergänzt werden.

Der Außenleiter kann eine Art Gehäuse für den Isolator bilden. Ferner kann der Außenleiter aus einem leitenden Material ausgebildet sein. Der Außenleiter kann folglich auf der Aufnahmeeinrichtung, also z.B. einer Trägerplatine, elektrisch z.B. mit Masse kontaktiert werden. Bei Kopplung mit einem Steckerende kann der Außenleiter ferner elektrisch mit einer elektrischen Schirmung bzw. Ummantelung des jeweiligen Steckers und der dazugehörigen Leitung verbunden werden. Somit kann eine durchgehende Schirmung der gesamten elektrischen Verbindung sichergestellt werden.

In noch einer weiteren Ausführungsform kann die Geometrie des Isolators und bei Vorhandensein des Außenleiters die Geometrie des Außenleiters derart ausgebildet sein, dass die Kapazitäten des ersten Kontakts und des zweiten Kontakts an jeder Position in der Kontaktvorrichtung ausgeglichen werden.

Bei dieser Ausführung können über die Wahl der Geometrie des Isolators und des Außenleiters die Kapazitäten entlang des ersten Kontakts und des zweiten Kontakts eingestellt werden. Die Kontaktvorrichtung bzw. die Leiterstrecken innerhalb der Kontaktvorrichtung können folglich als impedanzgeführte Leiterstrecken ausgebildet werden.

Es versteht sich ferner, dass um den Außenleiter ein Gehäuse für die Kontaktvorrichtung angeordnet werden kann, welches den Außenleiter aufnimmt und z.B. der mechanischen Fixierung der Kontaktvorrichtung auf einer Trägerplatine dienen kann.

Ferner können sowohl das Gehäuse, als auch der Außenleiter und/oder der Isolator mechanische Fixierungselemente zur mechanischen Fixierung eines Steckerendes in der Kontaktvorrichtung aufweisen.

In einer Ausführungsform können das erste Koppelende und das zweite Koppelende parallel zueinander in einer ersten Ebene angeordnet sein. Der erste Kontakt kann in einem ersten vorgegebenen Abstand von dem ersten Koppelende eine erste Biegung mit einem vierten vorgegebenen Winkel aus der ersten Ebene heraus aufweisen. Ferner kann der zweite Kontakt in einem zweiten vorgegebenen Abstand von dem zweiten Koppelende eine Biegung mit einem fünften vorgegebenen Winkel aus der ersten Ebene heraus aufweisen, wobei der zweite vorgegebene Abstand kleiner sein kann, als der erste vorgegebene Abstand.

Die erste Ebene wird durch die Längserstreckungsrichtungen des ersten Koppelendes und des zweiten Koppelendes definiert, die beide in der ersten Ebene liegen. Der vierte und der fünfte vorgegebene Winkel können in einer Ausführungsform jeweils als 90° bzw. annähernd 90° Winkel, also z.B. als Winkel zwischen 80° und 100° oder Winkel zwischen 85° und 95°, ausgebildet sein. Werden also die Koppelenden z.B. auf einer Trägerplatine befestigt, liegt die erste Biegung ausgehend von der Trägerplatine oberhalb der zweiten Biegung. Das erste Kontaktende liegt folglich ausgehend von der Trägerplatine ebenfalls oberhalb des zweiten Kontaktendes. Es versteht sich, dass der vierte vorgegebene Winkel und der fünfte vorgegebene Winkel identisch sein können. Alternativ können der vierte vorgegebene Winkel und der fünfte vorgegebene Winkel auch voneinander abweichen.

Es versteht sich, dass der Radius der Biegungen je nach Material, Bauraum und Anwendung entsprechend den Anforderungen angepasst werden kann. Insbesondere kann auch ein Knick anstelle einer Biegung vorgesehen werden.

In einer weiteren Ausführungsform kann der erste Kontakt in einem dritten vorgegebenen Abstand von dem ersten Koppelende eine dritte Biegung mit einem sechsten vorgegebenen Winkel parallel zur ersten Ebene aufweisen.

Es versteht sich, dass der sechste Winkel der dritten Biegung derart gewählt werden kann, dass die Biegung zum zweiten Kontakt hinzeigt. Der dritte Winkel kann dabei insbesondere kleiner als 90° sein.

Durch die dritte Biegung wird der aus der ersten Ebene herausstehende Teil des ersten Kontakts in Richtung des aus der ersten Ebene herausstehenden Teils des zweiten Kontakts verschoben. Der horizontale Abstand zwischen dem ersten Kontaktende und dem zweiten Kontaktende bezogen auf z.B. die Trägerplatine wird folglich verringert.

Es versteht sich, dass der erste Abstand und der dritte Abstand gleich groß sein können. Alternativ kann der erste Abstand größer oder kleiner als der dritte Abstand sein.

In noch einer Ausführungsform kann der zweite Kontakt in einem vierten vorgegebenen Abstand vom zweiten Koppelende eine Biegung mit einem siebten vorgegebenen Winkel parallel zu einer zweiten Ebene und in Richtung des ersten Kontakts aufweisen. Ferner kann der zweite Kontakt in einem fünften vorgegebenen Abstand eine fünfte Biegung mit einem achten vorgegebenen Winkel parallel zu der zweiten Ebene aufweisen. Der achte Winkel kann dabei den gleichen Betrag aufweisen, wie der siebte Winkel, und in die entgegensetzte Richtung zeigen, und der fünfte Abstand kann größer sein, als der vierte Abstand. Die zweite Ebene kann ferner orthogonal zu dem ersten Koppelende und/oder dem zweiten Koppelende angeordnet sein.

Die zweite Ebene steht orthogonal auf den Koppelenden und liegt damit parallel zu z.B. einer Trägerplatine auf welcher die Kontaktvorrichtung angeordnet werden kann. Die vierte und die fünfte Biegung bilden gemeinsam eine Art S-Kurve oder S-Biegung. Es versteht sich, dass die Radien der Biegungen gleich oder auch unterschiedlich groß sein können.

Insbesondere können die Radien und die Winkel der vierten und fünften Biegung in einer Ausführungsform derart gewählt werden, dass das zweite Kontaktende ausgehend von der Trägerplatine vertikal näher unter oder ganz unter dem ersten Kontaktende liegt. Die Kontaktenden liegen folglich bei einer Frontalansicht auf die Kontaktenden übereinander.

### Kurze Figurenbeschreibung

Nachfolgend werden vorteilhafte Ausführungsbeispiele der Erfindung unter Bezugnahme auf die begleitenden Figuren erläutert. Es zeigen:
- Figur 1: eine Frontalansicht eines Ausführungsbeispiels einer Kontaktvorrichtung gemäß der vorliegenden Erfindung;
- Figur 2: eine perspektivische Ansicht eines Ausführungsbeispiels eines ersten Kontakts und eines zweiten Kontakts gemäß der vorliegenden Erfindung;
- Figur 3: eine Frontansicht eines Ausführungsbeispiels eines ersten Kontakts und eines zweiten Kontakts gemäß der vorliegenden Erfindung;
- Figur 4: eine Explosionsansicht eines Ausführungsbeispiels einer Kontaktvorrichtung gemäß der vorliegenden Erfindung;
- Figur 5: eine perspektivische Ansicht eines weiteren Ausführungsbeispiels eines ersten Kontakts und eines zweiten Kontakts gemäß der vorliegenden Erfindung;
- Figur 6: eine perspektivische Ansicht eines weiteren Ausführungsbeispiels eines ersten Kontakts und eines zweiten Kontakts gemäß der vorliegenden Erfindung;
- Figur 7: eine perspektivische Ansicht eines weiteren Ausführungsbeispiels eines ersten Kontakts und eines zweiten Kontakts gemäß der vorliegenden Erfindung; und
- Figur 8: eine perspektivische Ansicht eines weiteren Ausführungsbeispiels eines ersten Kontakts und eines zweiten Kontakts gemäß der vorliegenden Erfindung.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

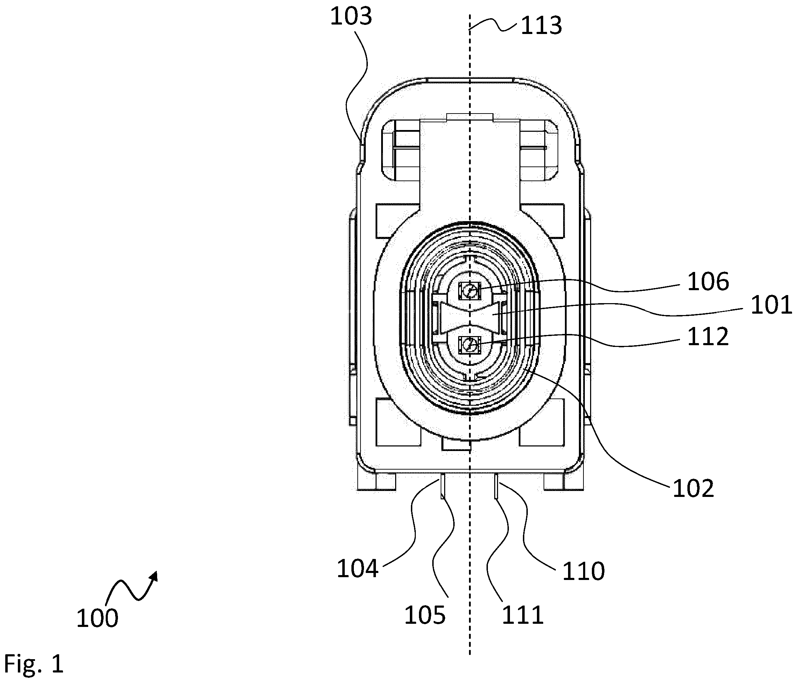

Figur 1 zeigt eine Frontalansicht einer Kontaktvorrichtung 100. Die Kontaktvorrichtung 100 kann z.B. auf eine Platine aufgesetzt werden, um diese mit dem Stecker eines Kabels elektrisch zu verbinden. Die Kontaktvorrichtung 100 weist ein Gehäuse 103 auf, in welchem ein Isolator 101 und ein Außenleiter 102 angeordnet sind. In dem Isolator 101 sind ein erster Kontakt 104 und ein zweiter Kontakt 110 angeordnet. Der erste Kontakt 104 weist ein erstes Koppelende 105 und ein erstes Kontaktende 106 auf. Der zweite Kontakt 110 weist ein zweites Koppelende 111 und ein zweites Kontaktende 112 auf.

In der Figur 1 ist ferner eine Mittelebene 113 eingezeichnet, welche die Kontaktvorrichtung 100 in der Hochachse der Länge nach schneidet.

Es ist in Figur 1 zu erkennen, dass die Kontaktenden 106, 112 der Kontakte 104, 110 vertikal übereinanderliegen. In der Ausführung der Figur 1 liegen die Kontaktenden 106, 112 in der Mittelebene 113. Bei herkömmlichen Buchsen liegen die Kontaktenden horizontal nebeneinander. Solche Buchsen benötigen daher in der Breite einen größeren Bauraum.

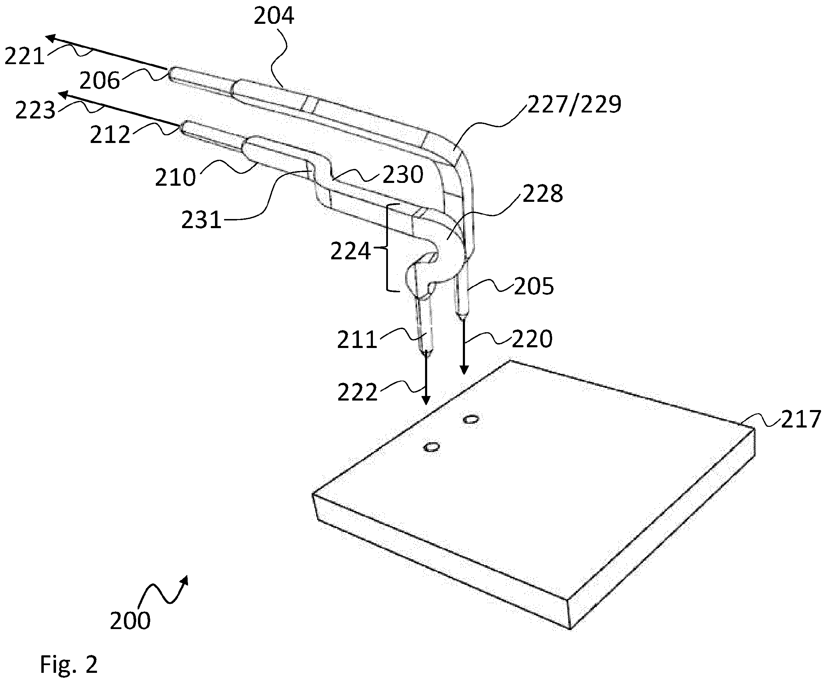

Um die Kontakte 104, 110 z.B. auf einer Trägerplatine (siehe Figur 2) vorteilhaft elektrisch kontaktieren zu können, sind bei der Kontaktvorrichtung 100 die Koppelenden 105, 111 der Kontakte 104, 110 horizontal nebeneinander angeordnet, also rechts und links der Mittelebene 113. Dadurch wird es möglich, die Koppelenden 105, 111 z.B. mit einem Empfängerbaustein zu verbinden, ohne für die Leiterbahnen einen entsprechenden Längenausgleich vorzusehen.

Obwohl in Figur 1 nicht ersichtlich, versteht sich, dass der erste Kontakt 104 und der zweite Kontakt 110 derart ausgebildet sind, dass sie gleich lang sind. Wie weiter unten im Detail erläutert, kann einer der Kontakte 104, 110 dazu einen Längenausgleichsabschnitt vorsehen, falls nötig.

Figur 2 zeigt eine perspektivische Ansicht eines ersten Kontakts 204 und eines zweiten Kontakts 210 einer Kontaktvorrichtung 200. In Figur 2 ist eine Trägerplatine 217 unter den Kontakten 204, 210 dargestellt, in welche das erste Koppelende 205 und das zweite Koppelende 211 eingeführt werden können.

Der erste Kontakt 204 weist neben dem ersten Koppelende 205 an dessen anderen Ende ein erstes Kontaktende 206 auf. Der zweite Kontakt 210 weist neben dem zweiten Koppelende 211 an dessen anderen Ende ein zweites Kontaktende 212 auf.

Das erste Koppelende 205 und das zweite Koppelende 211 sind länglich ausgebildet und stehen senkrecht auf der eben ausgebildeten Trägerplatine 217. Folglich stehen auch die Längserstreckungsrichtungen 220, 222 des ersten Koppelendes 205 und des zweiten Koppelendes 211 senkrecht auf der Trägerplatine 217.

Das erste Kontaktende 206 und das zweite Kontaktende 212 sind ebenfalls länglich ausgebildet. Allerdings liegen das erste Kontaktende 206 und das zweite Kontaktende 212 jeweils in einer Ebene, welche parallel zur Ebene der Trägerplatine 217 liegt. Dabei ist der vertikale Abstand zwischen dem ersten Kontaktende 206 und der Trägerplatine 217 größer, als der vertikale Abstand zwischen dem zweiten Kontaktende 212 und der Trägerplatine 217. Das erste Kontaktende 206 liegt folglich, wie auch in Figur 1 dargestellt, über dem zweiten Kontaktende 212.

Dabei steht die Längserstreckungsrichtung 220 des ersten Koppelendes 205 orthogonal zur Längserstreckungsrichtung 221 des ersten Kontaktendes 206. Ferner steht die Längserstreckungsrichtung 222 des zweiten Koppelendes 211 orthogonal zur Längserstreckungsrichtung 223 des zweiten Kontaktendes 212.

Um die oben erläuterten Positionen und Ausrichtungen für die Koppelenden 205, 211 und die Kontaktenden 206, 212 realisieren zu können, weisen der erste Kontakt 204 und der zweite Kontakt 210 jeweils eine spezifische Geometrie auf, welche unterschiedliche Biegungen aufweisen.

Der Übersichtlichkeit halber werden die im Folgenden genannten Abstände und Radien in der Figur 2 nicht separat mit Bezugszeichen versehen. Es versteht sich ferner, dass die in Figur 2 dargestellten Kontakte 204, 210 lediglich beispielhafter Natur sind. In anderen Ausführungsformen können sowohl die genannten Abstände als auch die genannten Radien an die jeweilige Anwendung angepasst werden. Dies gilt analog für die weiteren Figuren.

Der erste Kontakt 204 weist in einem ersten vorgegebenen Abstand von dem ersten Koppelende 205 eine erste Biegung 227 auf. Die erste Biegung 227 ist parallel zu einer ersten Ebene durch die Längserstreckungsrichtung 220 des ersten Koppelendes 205 und die Längserstreckungsrichtung 222 des zweiten Koppelendes 211. Bezogen auf die Figur 1, wird durch die erste Biegung das Kontaktende 206 auf die Mittelebene gekippt bzw. verschoben. Der Winkel und der Radius der ersten Biegung 227 sind dabei derart gewählt, dass das erste Kontaktende 206 in seiner finalen Position, also mit der unten beschriebenen dritten Biegung 229, in einer Frontalansicht auf einer vertikalen Ebene zwischen dem ersten Koppelende 205 und dem zweiten Koppelende 211 liegt.

Der zweite Kontakt 210 weist in einem zweiten Abstand von dem zweiten Koppelende 211 eine zweite Biegung 228 auf. Die zweite Biegung 228 ist im Gegensatz zur ersten Biegung 227 parallel zu einer zweiten Ebene durch die Längserstreckungsrichtung 221 des ersten Kontaktendes 206 und die Längserstreckungsrichtung 223 des zweiten Kontaktendes 212. Die zweite Biegung kippt das zweite Kontaktende 212 folglich aus der ersten Ebene heraus von der Trägerplatine 217 weg. Da das zweite Kontaktende 212 unterhalb des ersten Kontaktendes 206 liegt, ist der zweite Abstand geringer als der erste Abstand. Auch für die zweite Biegung 228 gilt, dass der Winkel und der Radius derart gewählt werden, dass das zweite Kontaktende 212 in seiner finalen Position in einer Frontalansicht auf der vertikalen Ebene zwischen dem ersten Koppelende 205 und dem zweiten Koppelende 211 liegt.

Bei dem ersten Kontakt 204 ist an der Position der ersten Biegung 227 eine dritte Biegung 229 vorhanden. Der beanspruchte dritte Abstand ist in diesem Beispiel identisch mit dem ersten Abstand. Die zweite Biegung 229 kippt das erste Kontaktende 206 aus der ersten Ebene heraus von der Trägerplatine 217 weg. Die erste Biegung 227 und die dritte Biegung 229 können auch als eine dreidimensionale Biegung bzw. eine Biegung um eine entsprechend schräg im Raum liegende Achse angesehen werden.

Um das zweite Kontaktende 212 vertikal unter dem ersten Kontaktende 206 zu positionieren, weist der zweite Kontakt 210 einen S-förmigen Abschnitt mit einer vierten Biegung 230 und einer fünften Biegung 231 auf. Die Biegungen 230, 231 liegen in einer Ebene parallel zur Trägerplatine 217 und weisen jeweils einen Winkel mit dem gleichen Betrag aber entgegengesetzter Richtung auf. Die Längserstreckungsrichtung des zweiten Kontakts 210 vor der vierten Biegung 230 ist folglich parallel zur Längserstreckungsrichtung des zweiten Kontakts 210 nach der fünften Biegung 231 und parallel zur Längserstreckungsrichtung 223 des zweiten Kontaktendes 212.

Schließlich weist der zweite Kontakt 210 einen Längenausgleichsabschnitt 224 auf, der mit der zweiten Biegung 228 kombiniert ist. Der Längenausgleichsabschnitt ist als eine Art Ausstülpung oder 180° Biegung ausgebildet. Der Radius dieser 180° Biegung ist derart gewählt, dass die Ausstülpung den erforderlichen Längenausgleich erzeugt. Es versteht sich, dass anstelle der gezeigten Ausstülpung andere Geometrien ebenfalls als Längenausgleich genutzt werden können. Bei dem zweiten Kontakt 210 sind die zweite Biegung 228 und der Längenausgleichsabschnitt 224 miteinander kombiniert ausgebildet. Es versteht sich, dass auch ein separater Längenausgleichsabschnitt möglich ist.

Die Geometrie des ersten Kontakts 204 und die Geometrie des zweiten Kontakts 210 sind derart gewählt, dass die Kontakte 204, 210 über ihre gesamte Länge einen Abstand zueinander aufweisen, der nur um einen vorgegebenen Schwellwert variiert. Der Abstand ist also annähernd konstant bzw. bewegt sich innerhalb eines tolerierbaren Bandes. Gleichzeitig weisen beide Kontakte 204, 210 die gleiche Länge auf.

In einer beispielhaften Ausführung kann der Abstand zwischen dem ersten Kontakt 204 und dem zweiten Kontakt 210 2 mm betragen. Der vorgegebene Schwellwert kann z.B. 0,5 mm oder 0,4 mm oder 0,3 mm oder 0,2 mm oder 0,1 mm oder 0 mm betragen.

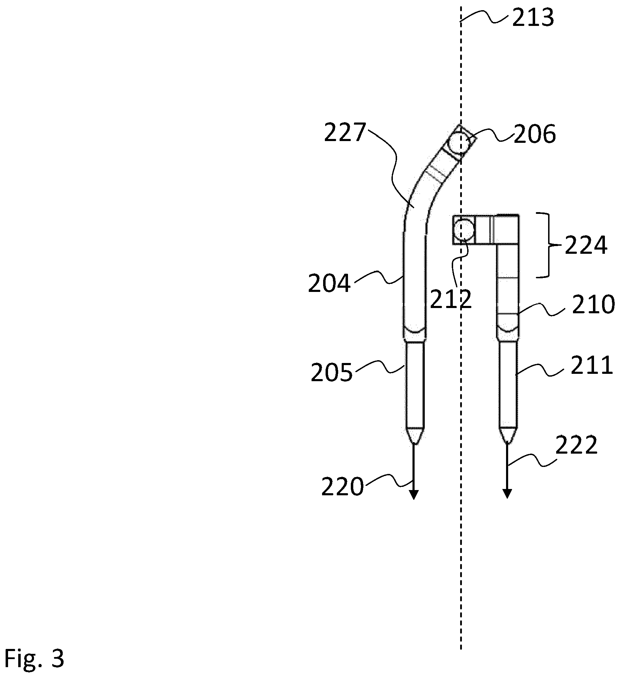

Figur 3 zeigt eine Frontansicht des ersten Kontakts 204 und des zweiten Kontakts 210. Bei dem ersten Kontakt 204 ist zu erkennen, dass die erste Biegung 227 derart gewählt ist, dass das erste Kontaktende 206 auf der Mittelebene 213 liegt. Bei dem zweiten Kontakt 210 sind die Biegungen nicht zu erkennen, da diese orthogonal zur Darstellungsebene liegen.

Allerdings ist auch zu erkennen, dass das zweite Kontaktende 212 ebenfalls auf der Mittelebene 213 liegt.

Gleichzeitig ist ebenfalls zu erkennen, dass das erste Koppelende 205 links von der Mittelebene 213 liegt, und das zweite Koppelende 211 rechts von der Mittelebene 213 liegt.

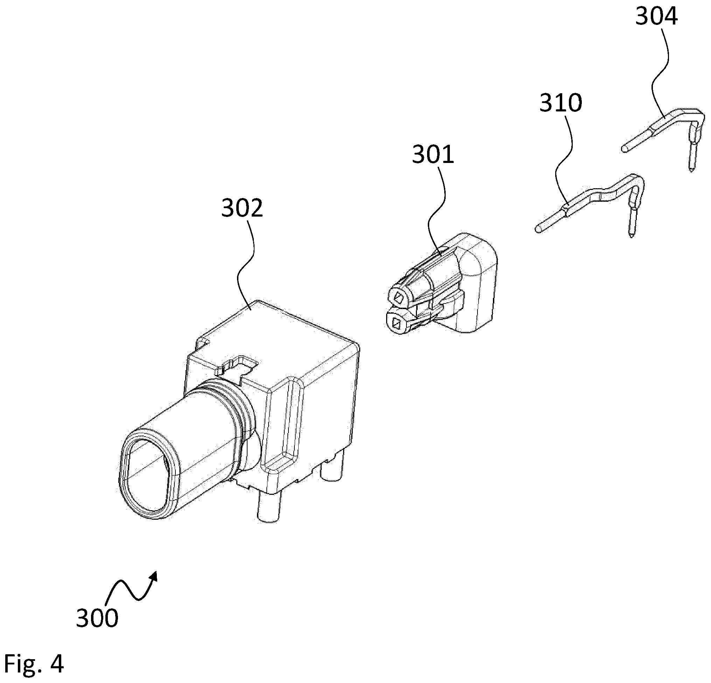

Figur 4 zeigt eine Explosionsansicht einer Kontaktvorrichtung 300. Die Kontaktvorrichtung 300 ist ohne ein entsprechendes Gehäuse dargestellt und weist einen Isolator 301 auf, welcher in einem Außenleiter 302 angeordnet wird. In dem Isolator 301 werden ein erster Kontakt 304 und ein zweiter Kontakt 310 angeordnet.

Der Außenleiter 302 weist eine ovale Öffnung auf, deren Längserstreckungsachse vertikal liegt. In dieser Öffnung wird der Isolator 301 angeordnet. Der Isolator 301 weist für jeden der Kontakte 304, 310 eine Führungsgeometrie auf, so dass ein Kontaktende des ersten Kontakts 304 vertikal über dem Kontaktende des zweiten Kontakts 310 geführt wird.

Es ist in Figur 3 ersichtlich, dass eine Buchse mit horizontal nebeneinanderliegenden Kontakten einen Außenleiter mit horizontal liegender Längserstreckungsachse benötigen würde. Die größte Ausdehnung des Ovals würde folglich in der Horizontalen liegen. Damit wäre eine solche Buchse deutlich breiter, als die Kontaktvorrichtung gemäß der vorliegenden Erfindung.

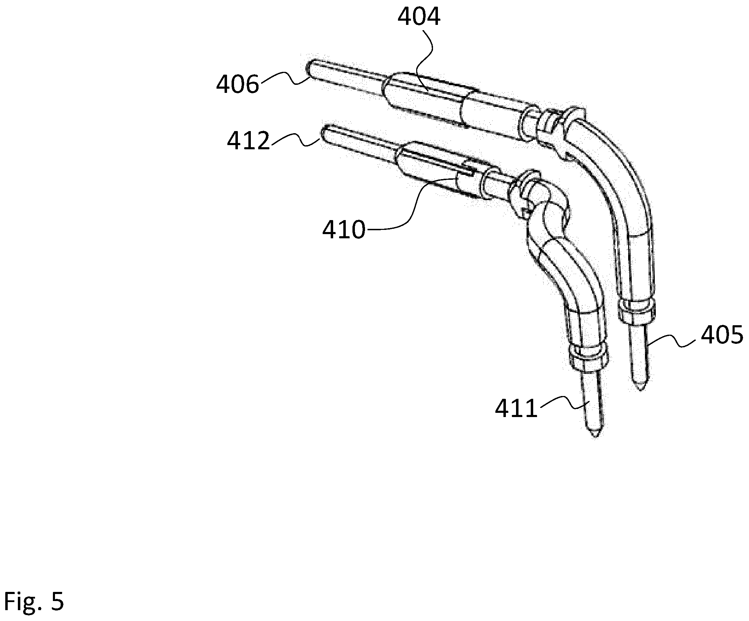

Die folgenden Figuren 5 bis 8 zeigen jeweils weitere Ausführungsmöglichkeiten für einen ersten Kontakt und einen zweiten Kontakt.

Es versteht sich, dass die Kontaktvorrichtungen 100, 200 und 300 mit jeder Ausführung eines Paars aus erstem Kontakt und zweitem Kontakt genutzt werden können. Insbesondere sind in solchen Ausführungsformen der Außenleiter und der Isolator entsprechend angepasst, um die Kontakte mit den entsprechenden Geometrien aufzunehmen.

Figur 5 zeigt eine perspektivische Ansicht eines ersten Kontakts 404 und eines zweiten Kontakts 410. Der erste Kontakt 404 weist ein erstes Koppelende 405 und ein erstes Kontaktende 406 auf. Der zweite Kontakt 410 weist ein zweites Koppelende 411 und ein zweites Kontaktende 412 auf. Die Koppelenden 405, 411 und die Kontaktenden 406, 412 sind ausgerichtet, wie z.B. die Koppelenden 205, 211 und die Kontaktenden 206, 212 der Figuren 2 und 3. Allerdings liegen die Koppelenden 405, 411 nicht symmetrisch zu der Ebene, welche durch die Kontaktenden 406, 412 aufgespannt wird.

Bei dem ersten Kontakt 404 ist keine erste Biegung vorhanden. Dies kann auch so verstanden werden, dass der für die erste Biegung vorgegebene Winkel 0° beträgt. In einer solchen Ausführungsform liegt der erste Kontakt 404 in einer Ebene, die in der Längserstreckungsrichtung des ersten Koppelendes 405 und der Längserstreckungsrichtung des ersten Kontaktendes 406 liegt. Die oben beschriebene dritte Biegung weist bei dem ersten Kontakt 404 einen Winkel von 90° auf.

Der zweite Kontakt 410 weist ausgehend von dem zweiten Koppelende 411 die zweite Biegung auf, welche in einen S-förmigen Abschnitt übergeht, so dass das zweite Kontaktende 412 in der oben genannten Ebene unter dem ersten Kontaktende 406 zu liegen kommt.

Bei dieser Ausführungsform liegen die Koppelenden 405, 411 nicht symmetrisch zu der Ebene durch die Kontaktenden 406, 412.

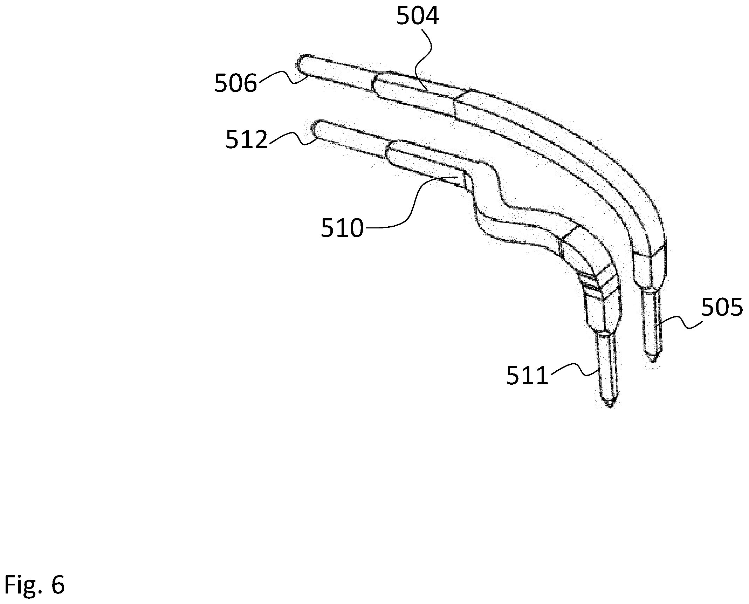

Figur 6 zeigt eine perspektivische Ansicht eines ersten Kontakts 504 und eines zweiten Kontakts 510. Der erste Kontakt 504 weist ein erstes Koppelende 505 und ein erstes Kontaktende 506 auf. Der zweite Kontakt 510 weist ein zweites Koppelende 511 und ein zweites Kontaktende 512 auf. Die Koppelenden 505, 511 und die Kontaktenden 506, 512 sind angeordnet, wie z.B. die Koppelenden 205, 211 und die Kontaktenden 206, 212 der Figuren 2 und 3.

Bei dem ersten Kontakt 504 wurden die o.g. erste Biegung und die o.g. dritte Biegung als kombinierte kurvenstetige Biegung ausgebildet.

Der zweite Kontakt 510 weist zur Positionierung des zweiten Kontaktendes 512 eine einzelne Biegung auf, welche die o.g. zweite Biegung und die o.g. vierte Biegung vereint. Im Verlauf dieser Biegung ist eine S-Schleife als Längenausgleich angeordnet. Anschließend ist die fünfte Biegung vorgesehen, so dass das zweite Kontaktende 512 parallel unter dem ersten Kontaktende 506 angeordnet wird.

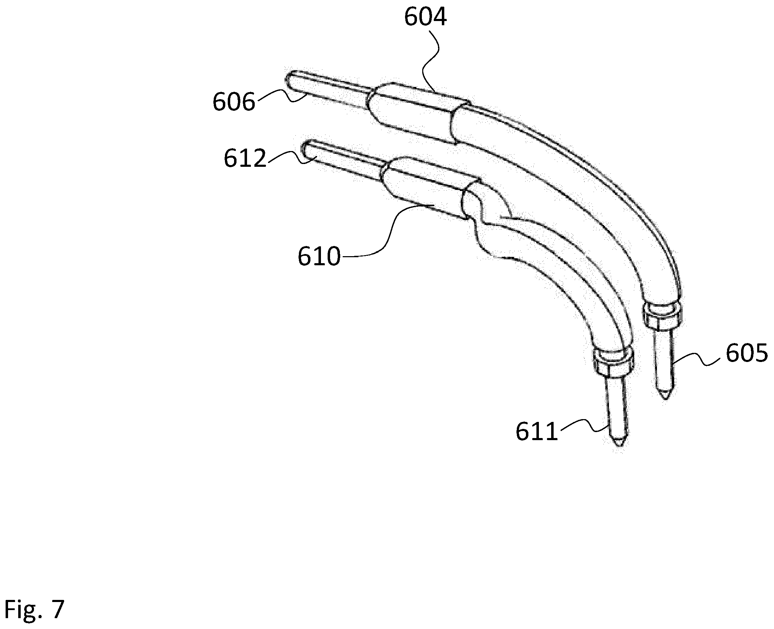

Figur 7 zeigt eine weitere perspektivische Ansicht eines ersten Kontakts 604 und eines zweiten Kontakts 610. Der erste Kontakt 604 weist ein erstes Koppelende 605 und ein erstes Kontaktende 606 auf. Der zweite Kontakt 610 weist ein zweites Koppelende 611 und ein zweites Kontaktende 612 auf. Die Koppelenden 605, 611 und die Kontaktenden 606, 612 sind angeordnet, wie z.B. die Koppelenden 205, 211 und die Kontaktenden 206, 212 der Figuren 2 und 3.

Der erste Kontakt 604 und der zweite Kontakt 610 weisen jeweils eine kurvenstetige Biegung auf, so dass das erste Koppelende 605 und das zweite Koppelende 611 symmetrisch neben einer Ebene liegen, welche durch die übereinander parallel zueinander liegenden Kontaktenden 606, 612 definiert wird. Der zweite Kontakt 610 kann über die Länge der kurvenstetigen Biegung z.B. einen S-förmigen Längenausgleichsabschnitt aufweisen.

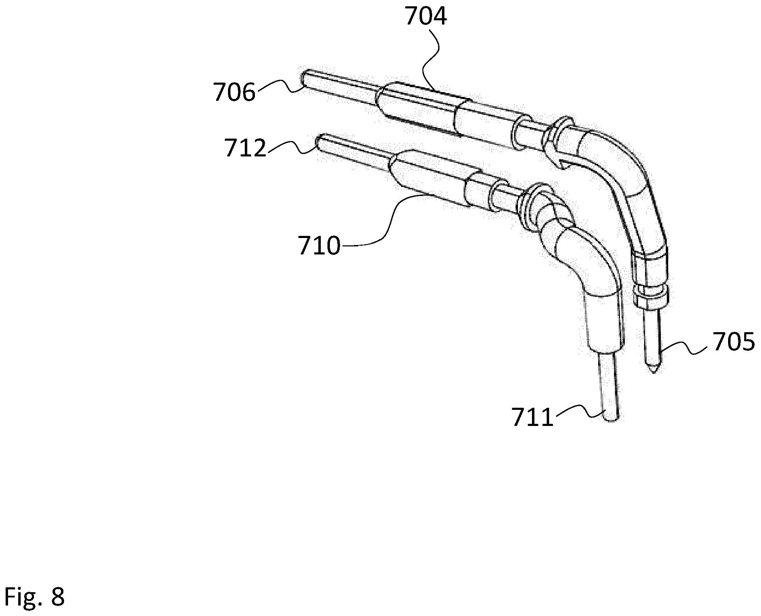

Figur 8 zeigt eine weitere perspektivische Ansicht eines ersten Kontakts 704 und eines zweiten Kontakts 710. Der erste Kontakt 704 weist ein erstes Koppelende 705 und ein erstes Kontaktende 706 auf. Der zweite Kontakt 710 weist ein zweites Koppelende 711 und ein zweites Kontaktende 712 auf. Die Koppelenden 705, 711 und die Kontaktenden 706, 712 sind angeordnet, wie z.B. die Koppelenden 205, 211 und die Kontaktenden 206, 212 der Figuren 2 und 3.

Der erste Kontakt 704 weist die erste Biegung in einem Abstand von dem ersten Koppelende 705 auf, welcher geringer ist, als der Abstand für die dritte Biegung. Die erste und die dritte Biegung sind folglich als separate Biegungen ausgeführt.

Der zweite Kontakt 710 weist sowohl eine zweite Biegung als auch die vierte und fünfte Biegung auf, wie bereits oben beschrieben. Es versteht sich, dass die Längen zwischen den Biegungen bzw. die Abstände, welche die Positionen der Biegungen auf der Länge des zweiten Kontakts 710 definieren, derart gewählt sind, dass der zweite Kontakt 710 so lang ist, wie der erste Kontakt 704 und der Abstand zwischen dem ersten Kontakt 704 und dem zweiten Kontakt 710 innerhalb des vorgegeben Bereichs liegt.

Es versteht sich, dass die Radien der zu den Figuren genannten Biegungen je nach Anwendung entsprechend gewählt werden können. Insbesondere können die Radien abhängig vom Durchmesser der einzelnen Kontakte gewählt werden. Die Radien können also z.B. ein Vielfaches bzw. ein Bruchteil des jeweiligen Durchmessers sein, beispielsweise 1- bis 5-mal der Durchmesser oder 0,5 bis 1-mal der Durchmesser. Die Radien können aber auch in absoluten Werten angegeben werden. Beispielsweise können die Radien zwischen 5 mm und 0 mm, insbesondere auch zwischen 2,5 mm und 0 mm, oder 1 mm und 0 mm, insbesondere auch zwischen 0,5 mm und 0 mm oder zwischen 0,25 mm und 0 mm bzw. zwischen 0,1 mm und 0 mm liegen. Ferner können die Abstände für die einzelnen Biegungen im Bereich von 0 % bis 100 % der Gesamtlänge des jeweiligen Kontakts liegen. Insbesondere auch im Bereich von 5 % bis 20%, oder von 10 % bis 30%, oder von 20 % bis 40%, oder von 30 % bis 50%, oder von 40 % bis 60%, oder von 50 % bis 70%, oder von 60 % bis 80%, oder von 70 % bis 90%, oder von 80 % bis 100%. In absoluten Werten können die Abstände z.B. zwischen 0 mm und 1 mm betragen, oder zwischen 1 mm und 2 mm, oder zwischen 2 mm und 5 mm, oder zwischen 5 mm und 7 mm, oder zwischen 7 mm und 10 mm, oder mehr.

Da es sich bei den vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft.

### BEZUGSZEICHENLISTE

- 100, 200, 300: Kontaktvorrichtung
- 101, 301: Isolator
- 102, 302: Außenleiter
- 103: Gehäuse

- 104, 204, 304, 404, 504, 604, 704: erster Kontakt
- 105, 205, 305, 405, 505, 605, 705: erstes Koppelende
- 106, 206, 306, 406, 506, 606, 706: erstes Kontaktende

- 110, 210, 310, 410, 510, 610, 710: zweiter Kontakt
- 111, 211, 311, 411, 511, 611, 711: zweites Koppelende
- 112, 212, 312, 412, 512, 612, 712: zweites Kontaktende

- 113, 213: Ebene

- 217: Aufnahmeeinrichtung

- 220: Längserstreckungsrichtung des ersten Koppelendes
- 221: Längserstreckungsrichtung des ersten Kontaktendes
- 222: Längserstreckungsrichtung des zweiten Koppelendes
- 223: Längserstreckungsrichtung des zweiten Kontaktendes

- 224: Längenausgleichsabschnitt

- 227: erste Biegung
- 228: zweite Biegung
- 229: dritte Biegung
- 230: vierte Biegung
- 231: fünfte Biegung

## Patentansprüche

1. Kontaktvorrichtung (100, 200, 300) zur Aufnahme eines Steckerendes, wobei die Kontaktvorrichtung (100, 200, 300) aufweist:
einen ersten Kontakt (104, 204, 304, 404, 504, 604, 704), der ein erstes Koppelende (105, 205, 305, 405, 505, 605, 705) und ein erstes Kontaktende (106, 206, 306, 406, 506, 606, 706) aufweist, und
einen zweiten Kontakt (110, 210, 310, 410, 510, 610, 710), der ein zweites Koppelende (111, 211, 311, 411, 511, 611, 711) und ein zweites Kontaktende (112, 212, 312, 412, 512, 612, 712) aufweist,
wobei die Koppelenden ausgebildet sind, den jeweiligen Kontakt elektrisch mit einer Aufnahmeeinrichtung (217) zu koppeln, und wobei die Kontaktenden ausgebildet sind, den jeweiligen Kontakt elektrisch mit einem Kontaktelement des Steckerendes zu verbinden,
wobei der kürzeste Abstand zwischen dem ersten Koppelende (105, 205, 305, 405, 505, 605, 705) und dem ersten Kontaktende (106, 206, 306, 406, 506, 606, 706) ungleich dem kürzesten Abstand zwischen dem zweiten Koppelende (111, 211, 311, 411, 511, 611, 711) und dem zweiten Kontaktende (112, 212, 312, 412, 512, 612, 712) ist,
wobei die Gesamtlänge des ersten Kontakts (104, 204, 304, 404, 504, 604, 704) gleich der Gesamtlänge des zweiten Kontakts (110, 210, 310, 410, 510, 610, 710) ist, insbesondere zuzüglich eines vorgegebenen Toleranzwertes,
wobei eine Verbindungslinie zwischen dem ersten Koppelende (105, 205, 305, 405, 505, 605, 705) und dem zweiten Koppelende (111, 211, 311, 411, 511, 611, 711) in einem dritten vorgegebenen Winkel von 90°, zu einer Ebene angeordnet ist, welche in der Längserstreckungsrichtung (221) des ersten Kontaktendes (106, 206, 306, 406, 506, 606, 706) und der Längserstreckungsrichtung (223) des zweiten Kontaktendes (112, 212, 312, 412, 512, 612, 712) liegt;
**dadurch gekennzeichnet, dass** über die gesamte Erstreckungslänge der Kontakte der kürzeste Abstand zwischen dem ersten Kontakt (104, 204, 304, 404, 504, 604, 704) und dem zweiten Kontakt (110, 210, 310, 410, 510, 610, 710) maximal um einen vorgegebenen Grenzwert variiert, wobei der Grenzwert 1 mm, 0,5 mm oder 0,25 mm, oder 20%, 10% oder 5% beträgt.

2. Kontaktvorrichtung (100, 200, 300) gemäß einem der vorhergehenden Ansprüche, wobei eine Längserstreckungsrichtung (220) des ersten Koppelendes (105, 205, 305, 405, 505, 605, 705) parallel zu einer Längserstreckungsrichtung (222) des zweiten Koppelendes (111, 211, 311, 411, 511, 611, 711) ausgebildet ist und wobei eine Längserstreckungsrichtung (221) des ersten Kontaktendes (106, 206, 306, 406, 506, 606, 706) parallel zu einer Längserstreckungsrichtung (223) des zweiten Kontaktendes (112, 212, 312, 412, 512, 612, 712) ausgebildet ist.

3. Kontaktvorrichtung (100, 200, 300) gemäß einem der vorhergehenden Ansprüche, wobei die Längserstreckungsrichtung (220) des ersten Koppelendes (105, 205, 305, 405, 505, 605, 705) in einem ersten vorgegebenen Winkel zu der Längserstreckungsrichtung (221) des ersten Kontaktendes (106, 206, 306, 406, 506, 606, 706) angeordnet ist, und/oder wobei die Längserstreckungsrichtung (222) des zweiten Koppelendes (111, 211, 311, 411, 511, 611, 711) in einem zweiten vorgegebenen Winkel zu der Längserstreckungsrichtung (223) des zweiten Kontaktendes (112, 212, 312, 412, 512, 612, 712) angeordnet ist, insbesondere wobei der erste vorgegebene Winkel dem zweiten vorgegebenen Winkel entspricht.

4. Kontaktvorrichtung (100, 200, 300) gemäß einem der vorhergehenden Ansprüche, wobei eine Verbindungslinie zwischen dem ersten Kontaktende (106, 206, 306, 406, 506, 606, 706) und dem zweiten Kontaktende (112, 212, 312, 412, 512, 612, 712) in einem vorgegebenen Winkel, insbesondere einem Winkel von -30° bis 30° oder einem Winkel von -10° bis 10° oder einem Winkel von 0° bis 5° oder einem Winkel von 0°, zu der Längserstreckungsrichtung (220) des ersten Koppelendes (105, 205, 305, 405, 505, 605, 705) oder der Längserstreckungsrichtung (222) des zweiten Koppelendes (111, 211, 311, 411, 511, 611, 711) angeordnet ist.

5. Kontaktvorrichtung (100, 200, 300) gemäß einem der vorhergehenden Ansprüche, wobei der erste Kontakt und/oder der zweite Kontakt zwischen dem ersten Koppelende (105, 205, 305, 405, 505, 605, 705) und dem ersten Kontaktende (106, 206, 306, 406, 506, 606, 706) einen Längenausgleichsabschnitt (224) aufweist, welcher insbesondere mäanderförmig ausgebildet ist.

6. Kontaktvorrichtung (100, 200, 300) gemäß einem der vorhergehenden Ansprüche, aufweisend einen Isolator (101, 301), welcher ausgebildet ist, den ersten Kontakt (104, 204, 304, 404, 504, 604, 704) und zweiten Kontakt (110, 210, 310, 410, 510, 610, 710) aufzunehmen, und welcher ein elektrisch isolierendes Material aufweist, und
insbesondere mit einem Außenleiter (102, 302), welcher ausgebildet ist, den Isolator (101, 301) aufzunehmen.

7. Kontaktvorrichtung (100, 200, 300) gemäß dem vorhergehenden Anspruch, wobei die Geometrie des Isolators (101, 301) und bei Vorhandensein des Außenleiters (102, 302) die Geometrie des Isolators (101, 301) derart ausgebildet werden, dass die Kapazitäten des ersten Kontakts (104, 204, 304, 404, 504, 604, 704) und des zweiten Kontakts an jeder Position in der Kontaktvorrichtung (100, 200, 300) ausgeglichen werden.

8. Kontaktvorrichtung (100, 200, 300) gemäß einem der vorhergehenden Ansprüche, wobei das erste Koppelende (105, 205, 305, 405, 505, 605, 705) und das zweite Koppelende (111, 211, 311, 411, 511, 611, 711) parallel zueinander in einer ersten Ebene angeordnet sind,
wobei der erste Kontakt in einem ersten vorgegebenen Abstand von dem ersten Koppelende (105, 205, 305, 405, 505, 605, 705) eine erste Biegung (227) mit einem vierten vorgegebenen Winkel aus der ersten Ebene heraus aufweist, und wobei der zweite Kontakt in einem zweiten vorgegebenen Abstand von dem zweiten Koppelende (111, 211, 311, 411, 511, 611, 711) eine zweite Biegung (228) mit einem fünften vorgegebenen Winkel aus der ersten Ebene heraus aufweist, wobei der zweite vorgegebene Abstand kleiner ist, als der erste vorgegebene Abstand.

9. Kontaktvorrichtung (100, 200, 300) gemäß dem vorhergehenden Anspruch, wobei der erste Kontakt in einem dritten vorgegebenen Abstand von dem ersten Koppelende (105, 205, 305, 405, 505, 605, 705) eine dritte Biegung (229) mit einem sechsten vorgegebenen Winkel parallel zur ersten Ebene aufweist.

10. Kontaktvorrichtung (100, 200, 300) gemäß dem vorhergehenden Anspruch, wobei der zweite Kontakt in einem vierten vorgegebenen Abstand vom zweiten Koppelende (111, 211, 311, 411, 511, 611, 711) eine vierte Biegung (230) mit einem siebten vorgegebenen Winkel parallel zu einer zweiten Ebene und in Richtung des ersten Kontakts (104, 204, 304, 404, 504, 604, 704) aufweist, und in einem fünften vorgegebenen Abstand eine fünfte Biegung (231) mit einem achten vorgegebenen Winkel parallel zu der zweiten Ebene aufweist, insbesondere wobei der achte Winkel den gleichen Betrag aufweist, wie der siebte Winkel, und in die entgegensetzte Richtung zeigt, und wobei der fünfte Abstand größer ist, als der vierte Abstand, und
wobei die zweite Ebene orthogonal zu dem ersten Koppelende (105, 205, 305, 405, 505, 605, 705) und/oder dem zweiten Koppelende (111, 211, 311, 411, 511, 611, 711) angeordnet ist.

## Claims

1. Contact device (100, 200, 300) for receiving a plug end, the contact device (100, 200, 300) having:
a first contact (104, 204, 304, 404, 504, 604, 704) which has a first coupling end (105, 205, 305, 405, 505, 605, 705) and a first contact end (106, 206, 306, 406, 506, 606, 706), and
a second contact (110, 210, 310, 410, 510, 610, 710) which has a second coupling end (111, 211, 311, 411, 511, 611, 711) and a second contact end (112, 212, 312, 412, 512, 612, 712),
wherein the coupling ends are designed to electrically couple the respective contact to a receiving device (217), and wherein the contact ends are designed to electrically connect the respective contact to a contact element of the plug end,
wherein the shortest distance between the first coupling end (105, 205, 305, 405, 505, 605, 705) and the first contact end (106, 206, 306, 406, 506, 606, 706) is not equal to the shortest distance between the second coupling end (111, 211, 311, 411, 511, 611, 711) and the second contact end (112, 212, 312, 412, 512, 612, 712),
wherein the total length of the first contact (104, 204, 304, 404, 504, 604, 704) is equal to the total length of the second contact (110, 210, 310, 410, 510, 610, 710), in particular plus a predetermined tolerance value,
wherein a connecting line between the first coupling end (105, 205, 305, 405, 505, 605, 705) and the second coupling end (111, 211, 311, 411, 511, 611, 711) is arranged at a third predetermined angle of 90° with respect to a plane lying in the direction of longitudinal extent (221) of the first contact end (106, 206, 306, 406, 506, 606, 706) and the direction of longitudinal extent (223) of the second contact end (112, 212, 312, 412, 512, 612, 712);
**characterized in that**, over the entire length of extent of the contacts, the shortest distance between the first contact (104, 204, 304, 404, 504, 604, 704) and the second contact (110, 210, 310, 410, 510, 610, 710) varies at most by a predetermined limit value, wherein the limit value is 1 mm, 0.5 mm or 0.25 mm, or 20%, 10% or 5%.

2. Contact device (100, 200, 300) according to one of the preceding claims, wherein a direction of longitudinal extent (220) of the first coupling end (105, 205, 305, 405, 505, 605, 705) is parallel to a direction of longitudinal extent (222) of the second coupling end (111, 211, 311, 411, 511, 611, 711), and wherein a direction of longitudinal extent (221) of the first contact end (106, 206, 306, 406, 506, 606, 706) is parallel to a direction of longitudinal extent (223) of the second contact end (112, 212, 312, 412, 512, 612, 712).

3. Contact device (100, 200, 300) according to one of the preceding claims, wherein the direction of longitudinal extent (220) of the first coupling end (105, 205, 305, 405, 505, 605, 705) is arranged at a first predetermined angle to the direction of longitudinal extent (221) of the first contact end (106, 206, 306, 406, 506, 606, 706), and/or wherein the direction of longitudinal extent (222) of the second coupling end (111, 211, 311, 411, 511, 611, 711) is arranged at a second predetermined angle to the direction of longitudinal extent (223) of the second contact end (112, 212, 312, 412, 512, 612, 712), in particular wherein the first predetermined angle corresponds to the second predetermined angle.

4. Contact device (100, 200, 300) according to one of the preceding claims, wherein a connecting line between the first contact end (106, 206, 306, 406, 506, 606, 706) and the second contact end (112, 212, 312, 412, 512, 612, 712) is arranged at a predetermined angle, in particular an angle of -30° to 30° or an angle of -10° to 10° or an angle of 0° to 5° or an angle of 0°, in relation to the direction of longitudinal extent (220) of the first coupling end (105, 205, 305, 405, 505, 605, 705) or the direction of longitudinal extent (222) of the second coupling end (111, 211, 311, 411, 511, 611, 711).

5. Contact device (100, 200, 300) according to one of the preceding claims, wherein the first contact and/or the second contact between the first coupling end (105, 205, 305, 405, 505, 605, 705) and the first contact end (106, 206, 306, 406, 506, 606, 706) has a length compensation section (224), which is designed in particular with a meandering shape.

6. Contact device (100, 200, 300) according to one of the preceding claims, having an insulator (101, 301) which is designed to receive the first contact (104, 204, 304, 404, 504, 604, 704) and second contact (110, 210, 310, 410, 510, 610, 710), and which comprises an electrically insulating material, and
in particular having an outer conductor (102, 302) which is designed to receive the insulator (101, 301).

7. Contact device (100, 200, 300) according to the preceding claim, wherein the geometry of the insulator (101, 301) and, if the outer conductor (102, 302) is present, the geometry of the insulator (101, 301) are formed in such a way that the capacitances of the first contact (104, 204, 304, 404, 504, 604, 704) and of the second contact are compensated at each position in the contact device (100, 200, 300).

8. Contact device (100, 200, 300) according to one of the preceding claims, wherein the first coupling end (105, 205, 305, 405, 505, 605, 705) and the second coupling end (111, 211, 311, 411, 511, 611, 711) are arranged parallel to each other in a first plane, wherein the first contact, at a first predetermined distance from the first coupling end (105, 205, 305, 405, 505, 605, 705), has a first bend (227) with a fourth predetermined angle out of the first plane, and wherein the second contact, at a second predetermined distance from the second coupling end (111, 211, 311, 411, 511, 611, 711), has a second bend (228) with a fifth predefined angle out of the first plane, wherein the second predetermined distance is smaller than the first predetermined distance.

9. Contact device (100, 200, 300) according to the preceding claim, wherein the first contact, at a third predetermined distance from the first coupling end (105, 205, 305, 405, 505, 605, 705), has a third bend (229) with a sixth predetermined angle parallel to the first plane.

10. Contact device (100, 200, 300) according to the preceding claim, wherein the second contact, at a fourth predetermined distance from the second coupling end (111, 211, 311, 411, 511, 611, 711), has a fourth bend (230) with a seventh predetermined angle parallel to a second plane and in the direction of the first contact (104, 204, 304, 404, 504, 604, 704), and, at a fifth predetermined distance, has a fifth bend (231) with an eighth predetermined angle parallel to the second plane, in particular wherein the eighth angle has the same value as the seventh angle and points in the opposite direction, and wherein the fifth distance is greater than the fourth distance, and
wherein the second plane is orthogonal to the first coupling end (105, 205, 305, 405, 505, 605, 705) and/or to the second coupling end (111, 211, 311, 411, 511, 611, 711).

## Revendications

1. Arrangement de contact (100, 200, 300) destiné à recevoir une extrémité de fiche, l'arrangement de contact (100, 200, 300) possédant :
un premier contact (104, 204, 304, 404, 504, 604, 704) qui possède une première extrémité d'accouplement (105, 205, 305, 405, 505, 605, 705) et une première extrémité de contact (106, 206, 306, 406, 506, 606, 706), et
un deuxième contact (110, 210, 310, 410, 510, 610, 710) qui possède une deuxième extrémité d'accouplement (111, 211, 311, 411, 511, 611, 711) et une deuxième extrémité de contact (112, 212, 312, 412, 512, 612, 712),
les extrémités d'accouplement étant configurées pour accoupler électriquement le contact respectif à un dispositif de réception (217), et les extrémités de contact étant configurées pour connecter électriquement le contact respectif à un élément de contact de l'extrémité de fiche,
la distance la plus courte entre la première extrémité d'accouplement (105, 205, 305, 405, 505, 605, 705) et la première extrémité de contact (106, 206, 306, 406, 506, 606, 706) étant différente de la distance la plus courte entre la deuxième extrémité d'accouplement (111, 211, 311, 411, 511, 611, 711) et la deuxième extrémité de contact (112, 212, 312, 412, 512, 612, 712),
la longueur totale du premier contact (104, 204, 304, 404, 504, 604, 704) étant égale à la longueur totale du deuxième contact (110, 210, 310, 410, 510, 610, 710), en particulier plus une valeur de tolérance prédéfinie, une ligne de liaison entre la première extrémité d'accouplement (105, 205, 305, 405, 505, 605, 705) et la deuxième extrémité d'accouplement (111, 211, 311, 411, 511, 611, 711) étant disposée selon un troisième angle prédéfini de 90° par rapport à un plan qui se trouve dans la direction d'extension longitudinale (221) de la première extrémité de contact (106, 206, 306, 406, 506, 606, 706) et la direction d'extension longitudinale (223) de la deuxième extrémité de contact (112, 212, 312, 412, 512, 612, 712) ;
**caractérisé en ce que** sur toute la longueur d'extension des contacts, la distance la plus courte entre le premier contact (104, 204, 304, 404, 504, 604, 704) et le deuxième contact (110, 210, 310, 410, 510, 610, 710) varie au maximum d'une valeur limite prédéfinie, la valeur limite étant de 1 mm, 0,5 mm ou 0,25 mm, ou de 20 %, 10 % ou 5 %.

2. Arrangement de contact (100, 200, 300) selon l'une des revendications précédentes, une direction d'extension longitudinale (220) de la première extrémité d'accouplement (105, 205, 305, 405, 505, 605, 705) étant configurée parallèle à une direction d'extension longitudinale (222) de la deuxième extrémité d'accouplement (111, 211, 311, 411, 511, 611, 711), et une direction d'extension longitudinale (221) de la première extrémité de contact (106, 206, 306, 406, 506, 606, 706) étant configurée parallèle à une direction d'extension longitudinale (223) de la deuxième extrémité de contact (112, 212, 312, 412, 512, 612, 712).

3. Arrangement de contact (100, 200, 300) selon l'une des revendications précédentes, la direction d'extension longitudinale (220) de la première extrémité d'accouplement (105, 205, 305, 405, 505, 605, 705) étant disposée à un premier angle prédéfini par rapport à la direction d'extension longitudinale (221) de la première extrémité de contact (106, 206, 306, 406, 506, 606, 706), et/ou la direction d'extension longitudinale (222) de la deuxième extrémité d'accouplement (111, 211, 311, 411, 511, 611, 711) étant disposée à un deuxième angle prédéterminé par rapport à la direction d'extension longitudinale (223) de la deuxième extrémité de contact (112, 212, 312, 412, 512, 612, 712), en particulier le premier angle prédéfini correspondant au deuxième angle prédéfini.

4. Arrangement de contact (100, 200, 300) selon l'une des revendications précédentes, une ligne de liaison étant disposée entre la première extrémité de contact (106, 206, 306, 406, 506, 606, 706) et la deuxième extrémité de contact (112, 212, 312, 412, 512, 612, 712) à un angle prédéterminé, en particulier un angle de -30° à 30° ou un angle de -10° à 10° ou un angle de 0° à 5° ou un angle de 0° par rapport à la direction d'extension longitudinale (220) de la première extrémité d'accouplement (105, 205, 305, 405, 505, 605, 705) ou la direction d'extension longitudinale (222) de la deuxième extrémité d'accouplement (111, 211, 311, 411, 511, 611, 711).

5. Arrangement de contact (100, 200, 300) selon l'une des revendications précédentes, le premier contact et/ou le deuxième contact présentant une portion de compensation de longueur (224), en particulier en forme de méandres, entre la première extrémité de couplage (105, 205, 305, 405, 505, 605, 705) et la première extrémité de contact (106, 206, 306, 406, 506, 606, 706).

6. Arrangement de contact (100, 200, 300) selon l'une des revendications précédentes, possédant un isolateur (101, 301), lequel est configuré pour recevoir le premier contact (104, 204, 304, 404, 504, 604, 704) et le deuxième contact (110, 210, 310, 410, 510, 610, 710), et lequel présente un matériau électriquement isolant, et comprenant notamment un conducteur extérieur (102, 302), lequel est configuré pour recevoir l'isolant (101, 301).

7. Arrangement de contact (100, 200, 300) selon la revendication précédente, la géométrie de l'isolateur (101, 301) et, si le conducteur extérieur (102, 302) est présent, la géométrie de l'isolateur (101, 301) sont configurées de telle sorte que les capacités du premier contact (104, 204, 304, 404, 504, 604, 704) et du deuxième contact à chaque position dans l'arrangement de contact (100, 200, 300) sont équilibrées.

8. Arrangement de contact (100, 200, 300) selon l'une des revendications précédentes, la première extrémité d'accouplement (105, 205, 305, 405, 505, 605, 705) et la deuxième extrémité d'accouplement (111, 211, 311, 411, 511, 611, 711) étant disposées parallèlement l'une à l'autre dans un premier plan,
le premier contact, à une première distance prédéfinie de la première extrémité d'accouplement (105, 205, 305, 405, 505, 605, 705), présentant une première courbure (227) avec un quatrième angle prédéfini hors du premier plan, et le deuxième contact, à une deuxième distance prédéfinie de la deuxième extrémité d'accouplement (111, 211, 311, 411, 511, 611, 711) présentant une deuxième courbure (228) avec un cinquième angle prédéfini hors du premier plan, la deuxième distance prédéfinie étant inférieure à la première distance prédéfinie.

9. Arrangement de contact (100, 200, 300) selon la revendication précédente, le premier, à une troisième distance prédéfinie de la première extrémité d'accouplement (105, 205, 305, 405, 505, 605, 705), présentant une troisième courbure (229) avec un sixième angle prédéfini parallèle au premier plan.

10. Arrangement de contact (100, 200, 300) selon la revendication précédente, le deuxième contact, à une quatrième distance prédéfinie de la deuxième extrémité d'accouplement (111, 211, 311, 411, 511, 611, 711), présentant une quatrième courbure (230) avec un septième angle prédéfini parallèle à un deuxième plan et dans la direction du premier contact (104, 204, 304, 404, 504, 604, 704) et, à une cinquième distance prédéfinie, présentant une cinquième courbure (231) avec un huitième angle prédéfini parallèle au deuxième plan, en particulier le huitième angle présentant la même valeur absolue que le septième angle et pointant dans la direction opposée, et la cinquième distance étant supérieure à la quatrième distance, et
le deuxième plan étant disposé orthogonalement à la première extrémité d'accouplement (105, 205, 305, 405, 505, 605, 705) et/ou à la deuxième extrémité d'accouplement (111, 211, 311, 411, 511, 611, 711).
